(19)

**Europäisches Patentamt**
**European Patent Office**
**Office européen des brevets**

(11) **EP 1 884 784 B1**

(12) **EUROPEAN PATENT SPECIFICATION**

(45) Date of publication and mention
of the grant of the patent:
**14.07.2010 Bulletin 2010/28**

(51) Int Cl.:
*G01R 19/00* (2006.01)    *G01R 15/14* (2006.01)
*H02M 3/156* (2006.01)

(21) Application number: **07108027.9**

(22) Date of filing: **11.05.2007**

(54) **Circuit and method for detecting electric current**

Schaltung und Verfahren zur Erkennung eines elektrischen Stromes

Circuit et procédé de détection du courant électrique

(84) Designated Contracting States:
**DE GB NL**

(30) Priority:  **02.08.2006  KR 20060073072**

(43) Date of publication of application:
**06.02.2008  Bulletin 2008/06**

(73) Proprietor: **Samsung Electronics Co., Ltd.**
**Suwon-si**
**Gyeonggi-do 443-742 (KR)**

(72) Inventor: **Lee, Seung-yo**
**Suwon-si (KR)**

(74) Representative: **Waddington, Richard**
**Appleyard Lees,**
**15 Clare Road**
**Halifax HX1 2HY (GB)**

(56) References cited:
**EP-A- 1 128 535      WO-A-2005/008878**
**US-A- 5 982 160      US-A1- 2003 071 636**
**US-B2- 6 894 471**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a circuit and method for detecting an electric current. More particularly, the present invention relates to a circuit and method for detecting an electric current which are capable of controlling the amount of electric current by detecting without loss the load current of a current source using a switching type converter when controlling the load current of the current source which requires a high current, and compensating electric current flowing in loads.

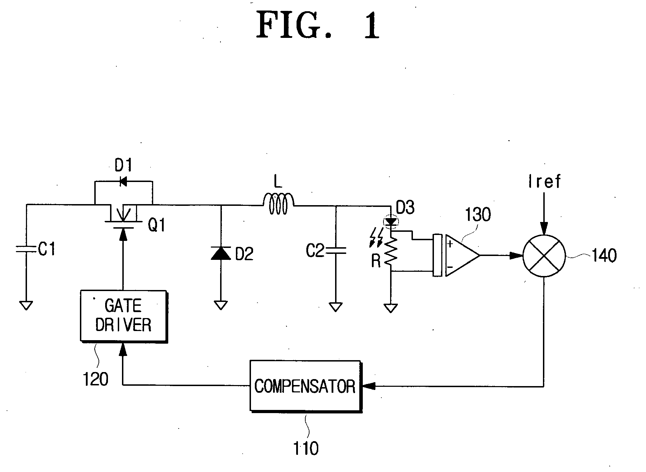

FIG. 1 is a schematic circuit diagram illustrating the structure of a related art switching type current-controlled converter.

The conventional switching type current-controlled converter is a buck type direct current (DC) converter, wherein an inductor-capacitor (LC) filter and a freewheeling diode D2 are connected to one side of a switching element Q1 typically implemented by a metal oxide semiconductor field effect transistor (MOSFET), and a load such as a light emitting diode D3 is connected in parallel to a capacitor C2 of the LC filter. In the LC filter, an inductor L is connected in series to the switching element Q1 and the capacitor C2 is connected in parallel to the inductor L.

Additionally, a differential amplifier 130 is connected to both sides of a resistor R in order to detect a current of the load-bearing light emitting diode D3, and a current error detector 140 is connected to an output end of the differential amplifier 130 in order to detect an error signal of an output current for a reference current Iref.

If the current error signal from the current error detector 140 is transmitted to a compensator 110, the compensator 110 drives the switching element Q1 through a gate driver 120 according to the current error signal so that the current flowing in the load-bearing light emitting diode D3 is controlled.

The related art switching type current-controlled converter with a current source having a topology such as the aforementioned buck converter includes a current controller to supply current necessary for the load. Additionally, in order to control the load current, a switch of the current source (the buck converter) has to be adjusted and a current detector for current feedback of the current controller is needed. Accordingly, the current detector uses a resistor for detecting a current or a Hall sensor to detect a load current. Consequently, the current is detected using the resistor or the hall sensor, and after the current is compared with the reference current, the difference is compensated through the controller (compensator).

Such method of detecting the current using the resistor has an associated drawback in that if a high current flows in the load, the circuit is over-heated. As a result, there is a substantial cost associated with cooling the circuit. In addition, if a Hall sensor is used, the bulk and complexity of the device increases and the manufacturing costs increase as a consequence.

Exemplary embodiments of the present invention address the above disadvantages and other disadvantages not described above.

US 2003/0071636 discloses a method and apparatus for near losselssly measuring inductor current.

WO2005/008878 discloses a system for operating DC motors and power converters.

The present invention addresses the aforementioned associated drawbacks and provides the following features described below.

The present invention provides a circuit and method for detecting an electric current which are capable of controlling the amount of electric current by detecting without loss a load current of a current source using a switching type converter when controlling the load current of the current source which requires a high current, and compensating electric current flowing in loads.

According to an aspect of the present invention there is provided a device according to claim 1.

Preferably, the electric current of the first inductor is an electric current flowing in the first inductor and an internal resistance of the first inductor.

Preferably, in the RC circuit, a first resistor and a first capacitor which are connected to each other in series are connected to the first inductor in parallel, and both ends of the first capacitor are connected to a first differential amplifier to detect the electric current of the first inductor.

Preferably, a voltage between both ends of the first capacitor is calculated using $V_{C1}(S) = R_{esr1}I_{L1}(S)$, where $R_{esr1}$ is the internal resistance of the first inductor and $I_{L1}$ is the electric current of the first inductor.

Preferably, the electric current of the second capacitor flows in the second capacitor and an internal resistance of the second capacitor.

Preferably, a voltage between both ends of the second inductor is calculated using $V_{L2}(S) = R_{esr2}I_{C2}$, where $R_{esr2}$ is the internal resistance of the second capacitor and $I_{C2}$ is the electric current of the second capacitor.

Preferably, the device further includes a current error detector which is operable to generate an error signal based on the difference current calculated by the subtractor and a reference current; a compensator which is operable to output a compensation signal to compensate the current flowing at the level of the error output from the current error detector; and a switching part which is operable to control the current flowing in the load according to the compensation signal output from the compensator.

Preferably, in the switching part, a first MOSFET is connected in series to the load and the first inductor, and a second MOSFET, which is grounded, is connected in parallel to the first MOSFET. Preferably, the switching part further comprises a gate driver which is operable to drive the first MOSFET and the second MOSFET according to the transmitted compensation signal.

Preferably, the first MOSFET and the second MOSFET are each embedded with a body diode which is connected inversely in parallel.

According to another aspect of the present invention there is provided a method according to claim 7.

Preferably, the electric current of the first inductor is an electric current flowing in the first inductor and an internal resistance of the first inductor.

Preferably, in the detecting the electric current of the first inductor, the electric current of the first inductor is detected through an RC circuit where a first resistor and a first capacitor which are connected to each other in series are connected to the first inductor in parallel, and both ends of the first capacitor are connected to a first differential amplifier to detect the electric current of the first inductor.

Preferably, a voltage between both ends of the first capacitor is calculated using $V_{C1}(S) = R_{esr1}I_{L1}(S)$, where $R_{esr1}$ is the internal resistance of the first inductor and $I_{L1}$ is the electric current of the first inductor.

Preferably, the electric current of the second capacitor is an electric current flowing in the second capacitor and an internal resistance of the second capacitor.

Preferably, a voltage between both ends of the second inductor is calculated using $V_{L2}(S) = R_{esr2}I_{C2}$, where $R_{esr2}$ is the internal resistance of the second capacitor and $I_{C2}$ is the electric current of the second capacitor. Preferably, the method further includes outputting a current error signal based on the difference current and a reference current; outputting a compensation signal to compensate the current flowing in the load as much as the current error signal; and controlling the current flowing in the load according to the compensation signal.

Preferably, the current is controlled by driving a first MOSFET which is connected in series to the load and the first inductor, and a second MOSFET which is connected in parallel to the first MOSFET according to the compensation signal.

For a better understanding of the invention, and to show how embodiments of the same may be carried into effect, reference will now be made, by way of example, to the accompanying diagrammatic drawings in which:

FIG. 1 is a schematic circuit diagram illustrating the structure of a related art switching type current-controlled converter;
FIG. 2 is a schematic circuit diagram illustrating the structure of a current detecting circuit according to an exemplary embodiment of the present invention; and
FIG. 3 is a flow chart illustrating a current detecting method according to an exemplary embodiment of the present invention.

Reference will now be made in detail to the present exemplary embodiments of the present invention, examples of which are illustrated in the accompanying drawings, wherein like reference numerals refer to like elements throughout. The exemplary embodiments are described below in order to explain the present invention by referring to the figures.

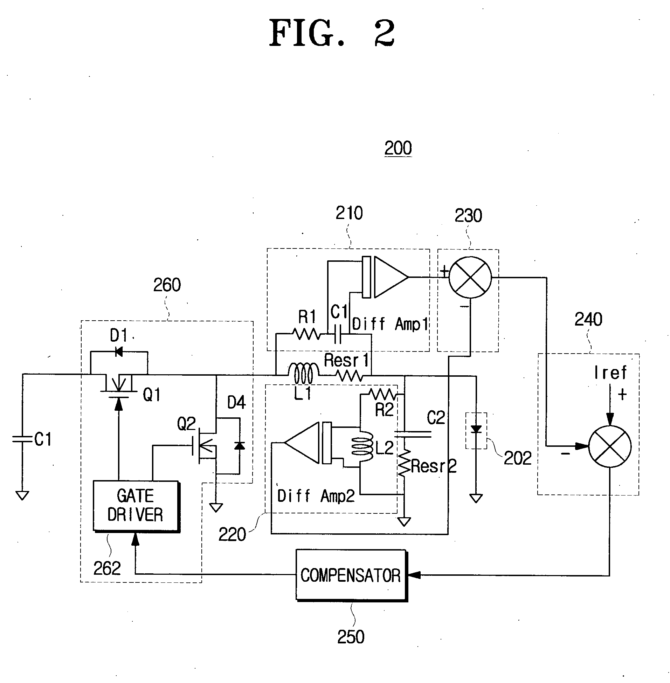

FIG. 2 is a schematic circuit diagram illustrating the structure of a current detecting circuit according to an exemplary embodiment of the present invention.

The current detecting circuit 200 according to an exemplary embodiment of the present invention comprises an RC circuit 210 which detects the current in a first inductor L1 connected to a load 202 in series, an LC circuit 220 which detects the current in a second capacitor C2 connected to the load 202 in parallel, and a subtractor 230 which calculates the difference between the current detected from the RC circuit 210 and the current detected from the LC circuit 220.

Additionally, the current detecting circuit 200 further comprises a current error detector 240 which outputs a current error signal in case of a discrepancy in current (error) between the difference current output from the subtractor 230 and a reference current Iref, a compensator 250 which outputs a compensation signal to compensate the current flowing in the load 202 at the level of the current error output from the current error detector 240, and a switching part 260 which controls the current flowing in the load 202 according to the compensation signal output from the compensator 250.

In the switching part 260, a first MOSFET Q1 is connected in series to the load 202 and the first inductor L1, and a second MOSFET Q2, which is grounded, is connected in parallel to the first MOSFET Q1. The switching part 260 further comprises a gate driver 262 which drives the first MOSFET Q1 and the second MOSFET Q2 according to the transmitted compensation signal.

The first MOSFET Q1 and the second MOSFET Q2 are switching elements each embedded with a body diode (D1 and D4 respectively) which is connected inversely in parallel.

The current of the first inductor L1 refers to the current flowing through the first inductor L1 and an internal resistance $R_{esr1}$ of the first inductor L1.

In the RC circuit 210, the first resistor R1 and the first capacitor C1 which are connected to each other in series are connected to the first inductor L1 in parallel, and a first differential amplifier Diff Amp 1 is connected to both ends of the first capacitor C1 in order to detect the current of the first inductor L1.

The voltage $V_{C1}$ between both ends of the first capacitor C1 can be calculated using Equation 1.

[Equation 1]

$$V_{C1}(S) = R_{esr1}I_{L1}(S)$$

where $R_{esr1}$ is the internal resistance of the first inductor L1, and $I_{L1}$ is the current of the first inductor L1.

The current of the second capacitor C2 refers to the current flowing through the second capacitor C2 and an internal resistance $R_{esr2}$ of the second capacitor C2.

In the LR circuit 220, the second resistor R2 and the second inductor L2 which are connected to each other in series are connected to the second capacitor C2 in parallel, and a second differential amplifier Diff Amp 2 is connected to both ends of the second inductor L2 in order to detect the current of the second capacitor C2.

The voltage $V_{L2}$ between both ends of the second inductor L2 can be calculated using Equation 2.

[Equation 2]

$$V_{C2}(S) = R_{esr2}I_{C2}$$

where $R_{esr2}$ is the internal resist of the second capacitor C2, and $I_{C2}$ is the current of the second capacitor C2.

The operation of a current detecting circuit according to an exemplary embodiment of the present invention will now be described.

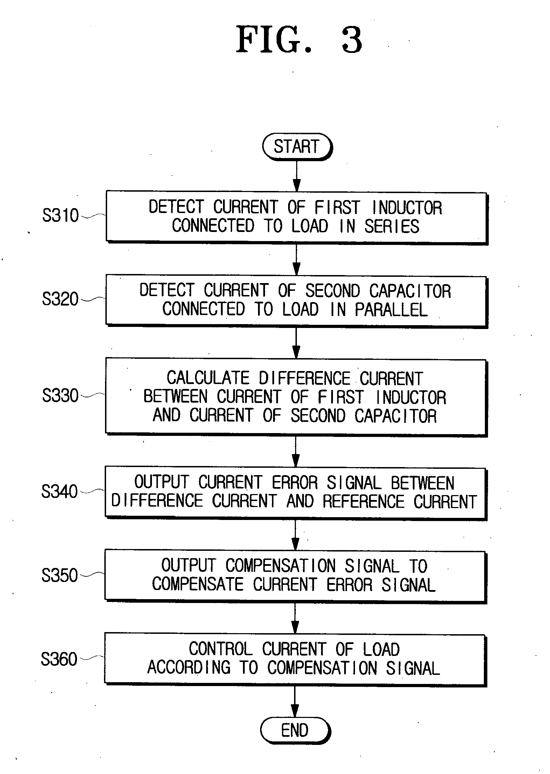

FIG. 3 is a flow chart illustrating a current detecting method according to an exemplary embodiment of the present invention.

A current source converter according to an exemplary embodiment of the present invention uses a synchronous buck converter and comprises an RC circuit 210 at one end and an LC circuit 220 at the other end of an LC filter of a buck converter in order to detect the load current.

The current flowing in the load 202 is measured by subtracting the ripple current of an output of the second capacitor C2 from the current flowing in the first inductor L1 of the buck converter.

For this, the current of the first inductor L1 connected to the load 202 in series is detected (S310).

That is, the inductor current of the buck converter is detected using the voltage of the first capacitor C1 of the RC circuit 210. The function operating between the current of the first inductor L1 and the voltage of the first capacitor C1 of the RC circuit 210 can be expressed as in Equation 3 below.

[Equation 3]

$$\frac{V_{C1}(S)}{I_{L1}(S)} = R_{esr1}\left[\frac{S/(R_{esr1}/L1)+1}{S/(1/R1C1)+1}\right]$$

The voltage of the first capacitor C1 causes effects such as resistor current sensing according to the condition of Equation 4 below, so the voltage of the first capacitor C1 is indirectly detected by the voltage of the first inductor L1 as in Equation 1.

[Equation 4]

$$\frac{1}{R1C1} = \frac{R_{esr1}}{L1}$$

The ripple current of the output capacitor is detected using the voltage of the inductor L2 of the LR circuit 220, and the current flowing in the load 202 is calculated using the subtractor 230. In order to compensate for the difference in current detected in the load current which is close to the reference current Iref, the compensator 250 drives the MOSFET using the gate driver 262.

For this, the current of the second capacitor C2 connected to the load 202 in parallel is detected (S320).

That is, the current of the second capacitor C2 is detected using the voltage of the second inductor L2 of the LR circuit 220 connected to the second capacitor C2, and the function between the current of the second capacitor C2 and the voltage of the second inductor L2 can be expressed as in Equation 5 below.

[Equation 5]

$$\frac{V_{L2}(S)}{I_{C2}(S)} = R_{esr2}\left[\frac{S+1/(R_{esr2}C2)}{S+(R2/L2)}\right]$$

The voltage of the second inductor L2 of the LR circuit 220 of Equation 5 indicates the ripple current of the second capacitor C2 according to the following condition.

In Equation 5, which shows the function between the current of the second capacitor C2 and the voltage of the second inductor L2, if the condition in Equation 6 is satisfied, the current of the second capacitor C2 can be detected according to resistor current sensing as in Equation 2.

[Equation 6]

$$\frac{1}{R_{esr2}C2} = \frac{R2}{L2}$$

As such, the difference current which is the difference between the current of the RC circuit 210 and the current of the LR circuit 220 detected according to the above process is calculated (S330).

That is, the scaled difference current flowing in the load 202 is calculated by subtracting the detected current of the LR circuit 220 calculated using Equation 2 from the detected current of the RC circuit 210 calculated using Equation 1.

Subsequently, the current error detector 240 outputs a current error signal using the detected load current signal and the reference current signal Iref (S340).

The current error signal output from the current error detector 240 is transmitted to the compensator 250 such as a current controller, to perform pulse-width modulation (PWM) operation. The compensator 250 generates a compensation signal to compensate the current flowing in the load 202 at the level of the current error based on the transmitted current error and outputs a compensation signal to adjust the duty of the switching part 260 (S350).

In the switching part 260, the gate driver 262 drives the first MOSFET Q1 and the second MOSFET Q2 according to the compensation signal transmitted from the compensator 250 and consequently the current flows according to the compensation signal. Accordingly, the switching part 260 controls the current flowing in the load 202 according to the compensation signal (S360).

The present invention reduces the damage to the overall circuit compared to a related art method of detecting current using a resistor when detecting the load current of the current source with a high current. The present invention also reduces the amount of heat generated compared to such related art method. Additionally, the present invention enhances the overall efficiency of the current source device and decreases manufacturing costs.

Although a few preferred embodiments have been shown and described, it will be appreciated by those skilled in the art that various changes and modifications might be made without departing from the scope of the invention, as defined in the appended claims.

**Claims**

1. A device for detecting an electric current, the device comprising:

   a first circuit (210) which is operable to detect an electric current of a first inductor (L1) connected in series to a load (202);
   a second circuit (220) which is operable to detect an electric current of a second capacitor (C2) connected in parallel to the load (202); and
   a subtractor (230) which is operable to calculate a difference current, which is a difference in current between the electric current detected in the first circuit (210) and the electric current detected in the second circuit (220);
   wherein in the second circuit (220), a second resistor (R2) and a second inductor (L2) are connected to each other in series, the second resistor (R2) and the second inductor (L2) are connected to the second capacitor (C2) in parallel, and both ends of the second inductor (L2) are connected to a second differential amplifier (Diff Amp 2) to detect the electric current of the second capacitor (C2).

2. The device of claim 1, wherein the electric current of the capacitor is an electric current flowing in the second capacitor (C2) and an internal resistance of the capacitor.

3. The device of claim 1 or claim 2, wherein a voltage between both ends of the second inductor (L2) is calculated using $V_{L2}(S)=R_{esr2}I_{C2}$, where Resr2 is the internal resistance of the second capacitor (C2) and $I_{C2}$ is the electric current of the second capacitor (C2).

4. The device of any preceding claim, further comprising:

   a current error detector (240) which is operable to generate an error signal based on the difference current calculated by the subtractor (230) and a reference current;
   a compensator (250) which is operable to output a compensation signal to compensate the current flowing at a level of an error output from the current error detector (240); and
   a switching part (260) which is operable to control the current flowing in the load (202) according to the compensation signal output from the compensator (250).

5. The device of claim 4, wherein the current error detector (240) is operable to generate an error signal if there is a discrepancy in current between the difference current and the reference current.

6. The device of claim 5, wherein the level of the error output from the current error detector (240) indicates the discrepancy in current between the difference current and the reference current.

7. A method of detecting an electric current, comprising:

   detecting an electric current of a first inductor (L1) connected in series to a load (202);
   detecting an electric current of a second capacitor (C2) connected in parallel to the load (202); and
   calculating a difference current which is a difference in current between the electric current detected in the first circuit (210) and the electric current detected in the second circuit (220);
   wherein in the detecting the electric current of the second capacitor (C2), the electric current of the second capacitor (C2) is detected through an inductor-resistor (LR) circuit where a second resistor (R2) and a second inductor (L2) are connected to each other in series, the second resistor (R2) and the second inductor (L2) are connected to the second capacitor (C2) in parallel, and both ends of the second inductor (L2) are connected to a second differential amplifier (Diff Amp 2) to detect the electric current of the second capacitor (C2).

8. The method of claim 7, wherein the electric current of the second capacitor (C2) is an electric current flowing in the second capacitor (C2) and an internal resistance of the second capacitor (C2).

9. The method of claim 7 or claim 8, wherein a voltage between both ends of the second inductor (L2) is calculated using $V_{L2}(S) = R_{esr2}I_{C2}$, where Resr2 is the internal resistance of the second capacitor (C2) and $I_{C2}$ is the electric current of the second capacitor (C2).

10. The method of any one of claims 7 to 9, further comprising:

    outputting a current error signal based on the difference current and a reference current;
    outputting a compensation signal to compensate the current flowing in the load (202) at a level of an error indicated in the current error signal; and
    controlling the current flowing in the load (202) according to the compensation signal.

11. The method of claim 10, wherein the current error detector (240) signal is output if there is a discrepancy in current between the difference current and the reference current.

12. The method of claim 11, wherein the level of the error indicated in the current error signal represents the discrepancy in current between the difference current and the reference current.

**Patentansprüche**

1. Einrichtung zum Detektieren eines elektrischen Stroms, wobei die Einrichtung Folgendes umfasst:

    eine erste Schaltung (210), die betreibbar ist, um einen elektrischen Strom einer mit einer Last (202) in Reihe geschalteten ersten Induktivität (L1) zu detektieren;
    eine zweite Schaltung (220), die betreibbar ist, um einen elektrischen Strom eines mit der Last (202) parallel geschalteten zweiten Kondensators (C2) zu detektieren; und
    einen Subtrahierer (230), der betreibbar ist, um einen Differenzstrom zu berechnen, der eine Stromdifferenz zwischen dem in der ersten Schaltung (210) detektierten elektrischen Strom und dem in der zweiten Schaltung (220) detektierten elektrischen Strom ist;
wobei in der zweiten Schaltung (220) ein zweiter Widerstand (R2) und eine zweite Induktivität (L2) miteinander in Reihe geschaltet sind, der zweite Widerstand (R2) und die zweite Induktivität (L2) mit dem zweiten Kondensator (C2) parallel geschaltet sind und beide Enden der zweiten Induktivität (L2) mit einem zweiten Differenzverstärker (Diff Amp 2) verbunden sind, um den elektrischen Strom des zweiten Kondensators (C2) zu detektieren.

2. Einrichtung nach Anspruch 1, wobei der elektrische Strom des Kondensators ein elektrischer Strom ist, der in dem zweiten Kondensator (C2) und in einem internen Widerstand des Kondensators fließt.

3. Einrichtung nach Anspruch 1 oder Anspruch 2, wobei eine Spannung zwischen beiden Enden der zweiten Induktivität (L2) unter Verwendung von $V_{L2}(S) = R_{esr2}I_{C2}$ berechnet wird, wobei Resr2 der interne Widerstand des zweiten Kondensators (C2) und $I_{C2}$ der elektrische Strom des zweiten Kondensators (C2) ist.

4. Einrichtung nach einem der vorhergehenden Ansprüche, ferner umfassend:

    einen Stromfehlerdetektor (240), der betreibbar ist, um auf der Basis des durch den Subtrahierer (230) berechneten Differenzstroms und eines Referenzstroms ein Fehlersignal zu erzeugen;
    einen Kompensator (250), der betreibbar ist, um ein Kompensationssignal auszugeben, um den Strom zu kompensieren, der bei einem Wert einer Fehlerausgabe des Stromfehlerdetektors (240) fließt; und
    einen Schaltteil (260), der betreibbar ist, um den in der Last (202) fließenden Strom gemäß dem aus dem Kompensator (250) ausgegebenen Kompensationssignal zu steuern.

5. Einrichtung nach Anspruch 4, wobei der Stromfehlerdetektor (240) betreibbar ist, um ein Fehlersignal zu erzeugen, wenn eine Stromdiskrepanz zwischen dem Differenzstrom und dem Referenzstrom besteht.

6. Einrichtung nach Anspruch 5, wobei der Wert der Fehlerausgabe des Stromfehlerdetektors (240) die Stromdiskrepanz zwischen dem Differenzstrom und dem Referenzstrom angibt.

7. Verfahren zum Detektieren eines elektrischen Stroms, mit den folgenden Schritten:

Detektieren eines elektrischen Stroms einer mit einer Last (202) in Reihe geschalteten ersten Induktivität (L1);

Detektieren eines elektrischen Stroms eines mit der Last (202) parallel geschalteten zweiten Kondensators (C2); und

Berechnen eines Differenzstroms, der eine Stromdifferenz zwischen dem in der ersten Schaltung (210) detektierten elektrischen Strom und dem in der zweiten Schaltung (220) detektierten elektrischen Strom ist;

wobei beim Detektieren des elektrischen Stroms des zweiten Kondensators (C2) der elektrische Strom des zweiten Kondensators (C2) durch eine Schaltung aus Induktivität und Widerstand (LR) detektiert wird, wobei ein zweiter Widerstand (R2) und eine zweite Induktivität (L2) miteinander in Reihe geschaltet sind, der zweite Widerstand (R2) und die zweite Induktivität (L2) mit dem zweiten Kondensator (C2) parallel geschaltet sind und beide Enden der zweiten Induktivität (L2) mit einem zweiten Differenzverstärker (Diff Amp 2) verbunden sind, um den elektrischen Strom des zweiten Kondensators (C2) zu detektieren.

**8.** Verfahren nach Anspruch 7, wobei der elektrische Strom des zweiten Kondensators (C2) ein elektrischer Strom ist, der in dem zweiten Kondensator (C2) und in einem internen Widerstand des zweiten Kondensators (C2) fließt.

**9.** Verfahren nach Anspruch 7 oder Anspruch 8, wobei eine Spannung zwischen beiden Enden der zweiten Induktivität (L2) unter Verwendung von $V_{L2}(S) = R_{esr2}I_{C2}$ berechnet wird, wobei Resr2 der interne Widerstand des zweiten Kondensators (C2) und $I_{C2}$ der elektrische Strom des zweiten Kondensators (C2) ist.

**10.** Verfahren nach einem der Ansprüche 7 bis 9, ferner mit den folgenden Schritten:

Ausgeben eines Stromfehlersignals auf der Basis des Differenzstroms und eines Referenzstroms;

Ausgeben eines Kompensationssignals, um den in der Last (202) fließenden Strom bei einem in dem Stromfehlersignal angegebenen Wert eines Fehlers zu kompensieren; und

Steuern des in der Last (202) fließenden Stroms gemäß dem Kompensationssignal.

**11.** Verfahren nach Anspruch 10, wobei das Signal des Stromfehlerdetektors (240) ausgegeben wird, wenn eine Stromdiskrepanz zwischen dem Differenzstrom und dem Referenzstrom besteht.

**12.** Verfahren nach Anspruch 11, wobei der in dem Stromfehlersignal angegebene Wert des Fehlers die Stromdiskrepanz zwischen dem Differenzstrom und dem Referenzstrom repräsentiert.

**Revendications**

**1.** Dispositif de détection d'un courant électrique, le dispositif comprenant :

un premier circuit (210) qui a pour fonction de détecter un courant électrique d'une première inductance (L1) connectée en série à une charge (202) ;

un second circuit (220) qui a pour fonction de détecter un courant électrique d'un second condensateur (C2) connecté en parallèle à la charge (202) ; et

un soustracteur (230) qui a pour fonction de calculer un courant de différence, qui est une différence de courant entre le courant électrique détecté dans le premier circuit (210) et le courant électrique détecté dans le second circuit (220) ;

dans lequel, dans le second circuit (220), une seconde résistance (R2) et une seconde inductance (L2) sont connectées l'une à l'autre en série, la seconde résistance (R2) et la seconde inductance (L2) sont connectées au second condensateur (C2) en parallèle, et

les deux extrémités de la seconde inductance (L2) sont connectées à un second amplificateur différentiel (Diff Amp 2) pour détecter le courant électrique du second condensateur (C2).

**2.** Dispositif selon la revendication 1, dans lequel le courant électrique du condensateur est un courant électrique passant dans le second condensateur (C2) et une résistance interne du condensateur.

**3.** Dispositif selon la revendication 1 ou la revendication 2, dans lequel une tension entre les deux extrémités de la seconde inductance (L2) est calculée conformément à $V_{L2}(S) = R_{esr2}I_{C2}$, où Resr2 est la résistance interne du second condensateur (C2) et $I_{C2}$ est le courant électrique du second condensateur (C2).

**4.** Dispositif selon l'une quelconque des revendications précédentes, comprenant en outre :

un détecteur d'erreur de courant (240) qui a pour fonction de générer un signal d'erreur sur la base du courant de différence calculé par le soustracteur (230) et d'un courant de référence ;

un compensateur (250) qui a pour fonction de délivrer un signal de compensation destiné à compenser le courant passant à un niveau d'une sortie d'erreur du détecteur d'erreur de courant (240) ; et

une partie de commutation (260) qui a pour fonction de commander le courant passant dans la charge (202) en fonction du signal de compensation délivré par le compensateur (250).

**5.** Dispositif selon la revendication 4, dans lequel le détecteur d'erreur de courant (240) a pour fonction de générer un signal d'erreur s'il y a un écart de courant entre le courant de différence et le courant de référence.

**6.** Dispositif selon la revendication 5, dans lequel le niveau de la sortie d'erreur du détecteur d'erreur de courant (240) indique l'écart de courant entre le courant de différence et le courant de référence.

**7.** Procédé de détection d'un courant électrique, consistant à :

détecter un courant électrique d'une première inductance (L1) connectée en série à une charge (202) ;

détecter un courant électrique d'un second condensateur (C2) connecté en parallèle à la charge (202) ; et

calculer un courant de différence, qui est une différence de courant entre le courant électrique détecté dans le premier circuit (210) et le courant électrique détecté dans le second circuit (220) ;

dans lequel, lors de la détection du courant électrique du second condensateur (C2), le courant électrique du second condensateur (C2) est détecté à travers un circuit inductance-résistance (LR) dans lequel une seconde résistance (R2) et une seconde inductance (L2) sont connectées l'une à l'autre en série, la seconde résistance (R2) et la seconde inductance (L2) sont connectées au second condensateur (C2) en parallèle, et

les deux extrémités de la seconde inductance (L2) sont connectées à un second amplificateur différentiel (Diff Amp 2) pour détecter le courant électrique du second condensateur (C2).

**8.** Procédé selon la revendication 7, dans lequel le courant électrique du second condensateur (C2) est un courant électrique passant dans le second condensateur (C2) et une résistance interne du second condensateur (C2).

**9.** Procédé selon la revendication 7 ou la revendication 8, dans lequel une tension entre les deux extrémités de la seconde inductance (L2) est calculée conformément à $V_{L2}(S) = R_{esr2}I_{C2}$, où Resr2 est la résistance interne du second condensateur (C2) et $I_{C2}$ est le courant électrique du second condensateur (C2).

**10.** Procédé selon l'une quelconque des revendications 7 à 9, consistant en outre à :

délivrer un signal d'erreur de courant (240) dépendant du courant de différence et d'un courant de référence ;

délivrer un signal de compensation destiné à compenser le courant passant dans la charge (202) à un niveau d'une erreur indiquée dans le signal d'erreur de courant ; et

réguler le courant passant dans la charge (202) en fonction du signal de compensation.

**11.** Procédé selon la revendication 10, dans lequel le signal du détecteur d'erreur de courant (240) est délivré s'il y a un écart de courant entre le courant de différence et le courant de référence.

**12.** Procédé selon la revendication 11, dans lequel le niveau de l'erreur indiquée dans le signal d'erreur de courant représente l'écart de courant entre le courant de différence et le courant de référence.

# FIG. 1

# FIG. 2

# FIG. 3

START

S310 — DETECT CURRENT OF FIRST INDUCTOR CONNECTED TO LOAD IN SERIES

S320 — DETECT CURRENT OF SECOND CAPACITOR CONNECTED TO LOAD IN PARALLEL

S330 — CALCULATE DIFFERENCE CURRENT BETWEEN CURRENT OF FIRST INDUCTOR AND CURRENT OF SECOND CAPACITOR

S340 — OUTPUT CURRENT ERROR SIGNAL BETWEEN DIFFERENCE CURRENT AND REFERENCE CURRENT

S350 — OUTPUT COMPENSATION SIGNAL TO COMPENSATE CURRENT ERROR SIGNAL

S360 — CONTROL CURRENT OF LOAD ACCORDING TO COMPENSATION SIGNAL

END

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030071636 A

- WO 2005008878 A